# EUROPEAN PATENT APPLICATION

(11) **EP 4 411 830 A1**
(43) Date of publication of application: **07.08.2024**
(21) Application number: 24153621.8
(22) Date of filing: 24.01.2024
(51) Int. Cl.: H01L 29/78, H01L 21/336, H01L 29/06, H01L 29/10

(54) **SILICON CARBIDE POWER MOSFET DEVICE HAVING IMPROVED PERFORMANCES AND MANUFACTURING PROCESS THEREOF**

(30) Priority: 31.01.2023 IT 202300001482
(71) Applicant: STMicroelectronics International N.V., 1228 Plan-les-Ouates, Geneva (CH)
(72) Inventor: SAGGIO, Mario Giuseppe, 95020 ACI BONACCORSI (CT) (IT); CAMALLERI, Cateno Marco, 95125 CATANIA (IT); SCALIA, Laura Letizia, 95037 SAN GIOVANNI LA PUNTA (CT) (IT); GUARNERA, Alfio, 95039 TRECASTAGNI (CT) (IT)
(74) Representative: Studio Torta S.p.A.

(57) **Abstract**

MOSFET device (50) of a vertical conduction type having a substrate (55) of silicon carbide having a first conductivity type and a main face (55A). A body region (60), of a second conductivity type, extends into the substrate (55), from the main face, and has a first depth along a first direction (Z). A first and a second source region (65) of the first conductivity type extend inside the body region (60), starting from the main face, parallel to each other, have a second depth, along the first direction (Z), smaller than the first depth and are mutually spaced by a distance, in a second direction (X), perpendicular to the first direction (Z). A body contact region (80), of the second conductivity type, extends inside the body region (60), between the first and the second source regions (65), and has a third depth, along the first direction, greater than or equal to the second depth (Z). The body contact region (80) has a width, in the second direction (X) and a length, in the extension direction (Y) of the source regions, much greater than its width.

## Description

### Technical field

The present invention relates to a silicon carbide power MOSFET device having improved performances and to the manufacturing process thereof.

### Background

As known, semiconductor materials having a wide bandgap, for example greater than 1.1 eV, low on-state resistance, high thermal conductivity, high operating frequency and high charge carrier saturation velocity allow manufacture of electronic devices, for example diodes and transistors, having better performances than silicon electronic devices, in particular for power applications, for example operating at voltages comprised between 600 V and 1300 V or in specific operating conditions such as at high temperature.

These electronic devices may be formed from a silicon carbide wafer in one of its polytypes, for example 3C-SiC, 4H-SiC and 6H-SiC, which distinguish thanks to the characteristics listed above.

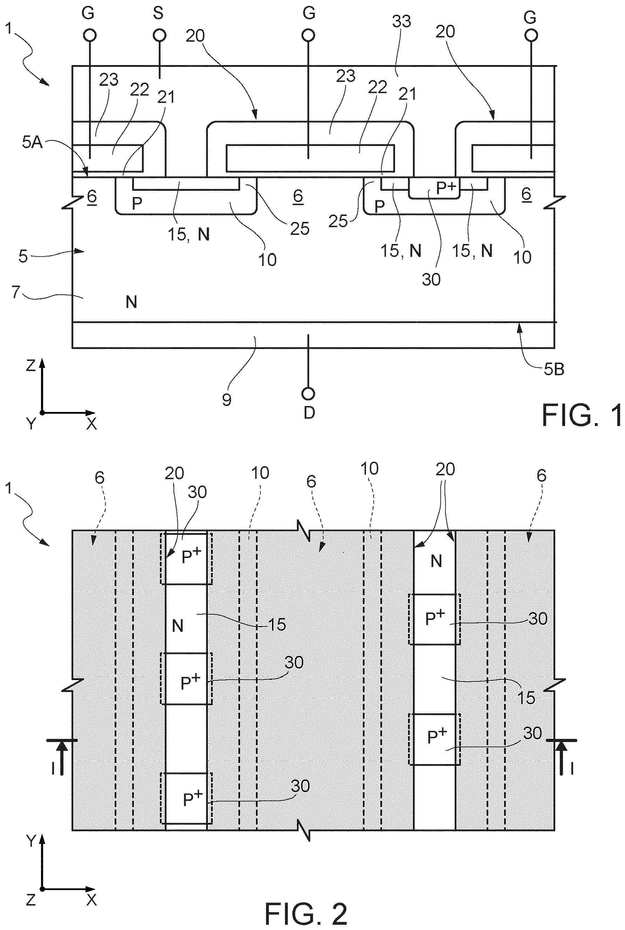

For example, Figure 1 shows a cross-section of a known MOSFET device 1 of a vertical conduction type, taken in a plane XZ of a Cartesian reference system XYZ comprising a first axis X, a second axis Y and a third axis Z.

The MOSFET device 1 is formed by a plurality of elementary cells which share a source terminal S and a drain terminal D. In Figures 1 and 2, the elementary cells (shown only in part) are equal to each other and extend in parallel in a same die.

The MOSFET device 1 is formed in a substrate 5 of silicon carbide having a first surface 5A and a second surface 5B.

The substrate 5 forms a drain region 7 (hereinafter also referred to as drift region), a plurality of body regions 10 and a plurality of source regions 15.

The drain region 7, here of N-type, extends between the first and the second surfaces 5A, 5B of the substrate 5.

A drain contact region 9, of conductive material, for example metal or silicide, extends on the second surface 5B of the substrate 5, in direct electrical contact with the drain region 7, and forms the drain terminal D of the MOSFET device 1.

The body regions 10 are here of P-type and extend into the substrate 5 from the first surface 5A.

In general, the MOSFET device 1 has a plurality of body regions 10 (in Figure 1, two are shown), extending in parallel along the second axis Y, as visible from Figure 2 wherein, for clarity of illustration, the top metallization (see below) extending above the first surface 5A of the substrate 5 is not shown.

Adjacent body regions 10 delimit, therebetween, surface portions 6 of the drain region 7, facing the first surface 5A of the substrate 5.

In a variant not shown, the body regions 10 may have a ring shape, in top view.

The source regions 15 extend from the first surface 5A of the substrate 5, each inside a respective body region 10, and are here of N-type.

Each source region 15 has a width, along the first axis X, smaller than the width of the respective body region 10 and a depth, along the third axis Z, smaller than the depth of the respective body region 10.

Each source region 15 and each adjacent surface portion 6 of the drain region 7 laterally delimit, inside a respective body region 10, a channel region 25.

The MOSFET device 1 further comprises a plurality of insulated gate regions 20. The insulated gate regions 20 are each formed by a gate insulating layer 21, in contact with the first surface 5A of the substrate 5; a gate conductive layer 22, directly superimposed on the gate insulating layer 21, and a passivation layer 23, covering the gate conductive layer 22 and sealing, together with the gate insulating layer 21, the gate conductive layer 22.

The gate conductive layers 22 of the insulated gate regions 20 are electrically connected in parallel, in a manner not shown here, forming a gate terminal G of the MOSFET device 1.

The MOSFET device 1 further comprises a plurality of body contact regions 30 and a front metallization region 33.

The body contact regions 30, which have the aim of creating an ohmic contact with the respective body regions 10, are of P+ type and extend each, from the first surface 5A of the substrate 5, inside a respective source region 15, in contact with a respective body region 10, or slightly protruding in the latter, as represented in Figure 1.

In particular, each source region 15 accommodates a plurality of body contact regions 30, arranged at a mutual distance along the second axis Y, as shown in Figure 2. Furthermore, as visible again in Figure 2, the body contact regions 30 of adjacent source regions 15 are offset. Consequently, in the cross-section of Figure 1, only one body contact region 30 is visible (in the source region 15 represented on the right) and the body contact regions 30 arranged in the source region 15 represented on the left are not visible.

The front metallization region 33, for example of metal and/or metal silicide, forms the source terminal S of the MOSFET device 1 and extends over the first surface 5A of the substrate 5 and over the insulated gate regions 20, in direct electrical contact with the source regions 15 and the body contact regions 30.

Each elementary cell of the MOSFET device 1 (formed by an insulated gate region 20 and by the adjacent portions of the body regions 10 and source regions 25, as well as by the underlying portion of the drain region 7) has a on threshold voltage Vₜₕ.

In use, if the voltage V_{GS} between the gate terminal G and the source terminal S is greater than the threshold voltage Vₜₕ, the MOSFET device 1 is in an on-state, the channel regions 25 are conductive, and a current may flow between the source terminal S and the drain terminal D, along conductive paths passing through the source regions 15, the channel regions 25 and the drift region 7.

In particular, when the MOSFET devices 1 are used in bridge or half-bridge switching circuits, they turn off when a voltage V_{GS} lower than their threshold voltage Vₜₕ is applied. In this step, the voltage V_{DS} between the source terminal S and the drain terminal D is applied to the PN junctions formed by the body regions 10 and by the drain region 7. A recirculation current therefore flows from the drift region 7 towards the front metallization region 33, collected by the body regions 10.

However, the presence of the body contact regions 30 entails both geometric and field non-uniformities in proximity of the source contacts which may give rise to non-ideal operation, in particular as the size of the MOSFET devices reduces, as required by the users.

In fact, the body contact regions 30 are formed by high-energy ion implant using a suitable mask, after implanting the source regions 25. The etch to obtain the mask for implanting the body contact regions 30 may however affect the previous source implant, reducing the dimensions of the channel regions 25 at the body contact regions 30; as a result, the dimensions of the channel regions 25 are not uniform along the strips forming the source regions 10 (etch loading effect).

Furthermore, the presence of the body contact regions 30 creates electric field non-uniformities, which affect the turning-on uniformity in the various portions of the elementary cells.

Last but not least, during turning off of the MOSFET transistor 1, in some areas of the device, the electric charges present in the channel regions 25 may directly reach the source regions, where they recombine, but, in other points, they have to bypass the body contact regions 30. In these other points a more resistive path is therefore present which causes a short delay in the electrical behavior.

However, this non-uniformity and uncertainties in the actual switching behavior of the MOSFET transistors of the indicated type are unwanted, especially in case of highfrequency switching operation.

The aim of the present invention is therefore to provide a MOSFET device overcoming the drawbacks of the prior art.

### Summary

According to the present invention, a power MOSFET device and a manufacturing process thereof are provided, as defined in the attached claims.

### Brief Description of the Drawings

For a better understanding of the present invention, an embodiment thereof is now described, purely by way of nonlimiting example, with reference to the attached drawings, wherein:
- Figure 1 shows a cross-section, taken along section line I-I of Figure 2, of a known silicon carbide MOSFET device of a vertical conduction type;
- Figure 2 is a top view, with parts removed, of the MOSFET device of Figure 1;
- Figure 3 shows a cross-section, taken along section line III-III of Figure 4A, of an embodiment of the present silicon carbide MOSFET device of a vertical conduction type;
- Figure 4A is a top view, with parts removed, of the MOSFET device of Figure 3;
- Figure 4B is another top view with further parts removed;
- Figures 5A-5C are cross-sections similar to Figure 3, in successive manufacturing steps of the present MOSFET device; and
- Figures 6A-6C are top views corresponding to figures 5A-5C, in the manufacturing steps denoted by the same letter A-C.

### Description of Embodiments

The following description refers to the arrangement shown; consequently, expressions such as "above", "below", "top", "bottom", "right", "left" relate to the accompanying Figures and are not to be interpreted in a limiting manner.

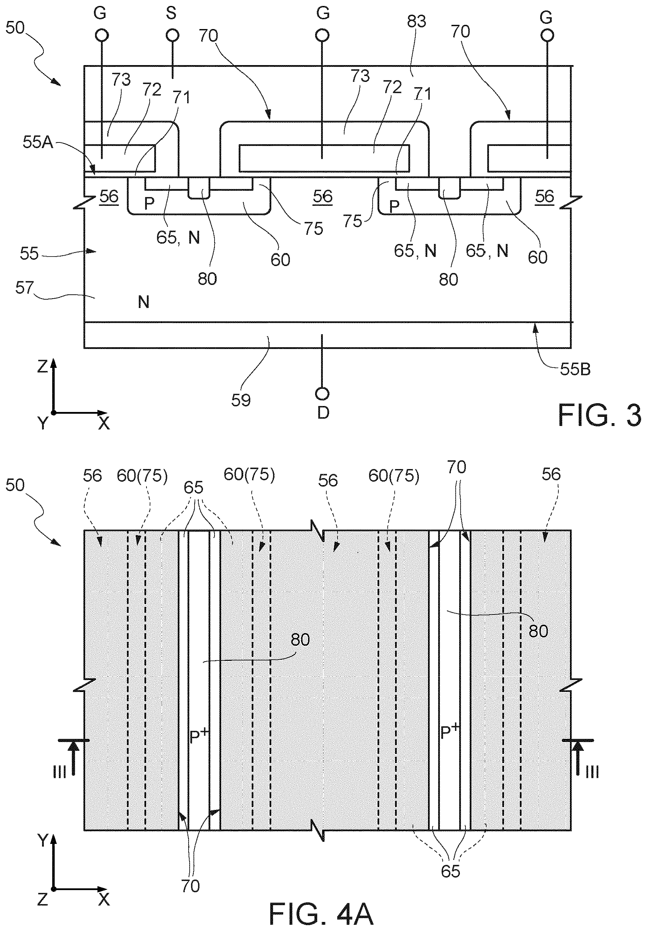

Figures 3 and 4A show a MOSFET device 50 of a vertical conduction type, respectively in a cross-section taken in a plane XZ of a Cartesian reference system XYZ comprising a first axis X, a second axis Y and a third axis Z and in top view.

The MOSFET device 50 is formed by a plurality of elementary cells which share a source terminal S and a drain terminal D. In Figures 3 and 4A, the elementary cells (shown only in part) are equal to each other and are arranged in parallel in a same die.

The MOSFET device 50 is formed in a substrate 55 of silicon carbide having a first surface 55A and a second surface 55B.

The substrate 55 forms a drain region 57 (hereinafter also referred to as drift region), a plurality of body regions 60, a plurality of source regions 65 (here, two source regions 65 for each body region 60) and a plurality of body contact regions 80 (one body contact region 80 for each body region 60).

The drain region 57, of a first conductivity type, here of N-type, extends between the first and the second surfaces 55A, 55B of the substrate 55.

A drain metallization region 59, of conductive material, for example of metal or silicide, extends over the second surface 55B of the substrate 55, in direct electrical contact with the drain region 57, and forms the drain terminal D of the MOSFET device 50.

The body regions 60 have a second conductivity type, here of P-type, and extend into the substrate 55 from the first surface 55A. Each body region 60 has a doping level for example comprised between 1.10¹⁷ atoms/cm³ and 1.10²⁰ atoms/cm³, a depth (along the third axis Z) comprised between 0.3 um and 2 um and a width (along the first axis X) linked to the pitch (distance between adjacent cells), for example of 0.4-6 um.

In general, the MOSFET device 50 has a plurality of body regions 60 (two shown in Figures 3 and 4A), extending along the second axis Y and parallel to each other, as visible from Figure 4A wherein, for clarity of illustration, the source metallization (see below) arranged above the first surface 55A of the substrate 55 is not shown.

Adjacent body regions 60 delimit, therebetween, surface portions 56 of the drain region 57, facing the first surface 55A of the substrate 55.

In a variant not shown, the body regions 60 may have a circular or ring shape, in top view.

The source regions 65 each extend from the first surface 55A of the substrate 55 inside a respective body region 60 and have the first conductivity type, here of N-type, for example with a doping level comprised between 1·10¹⁸ atoms/cm³ and 1·10²⁰ atoms/cm³.

As indicated above, in the MOSFET device 50, each body region 60 accommodates two source regions 65 which are distinct and arranged side by side, at a mutual distance.

The source regions 65, for example equal to each other, have the same depth, along the third axis Z, which is smaller than the depth of the respective body region 60.

Each source region 65 and each adjacent surface portion 56 of the drain region 57 laterally delimit, inside a respective body region 60, a channel region 75.

In the MOSFET device 50, in a same body region 60, a body contact region 80 extends between two adjacent source regions.

Each body contact region 80 extends from the first surface 55A of the substrate 55, between two respective source regions 65, in electrical contact with the respective body region 60, or slightly protruding into the latter, as represented in Figure 3.

The body contact regions 80, which have the aim of creating an ohmic contact for the respective body regions 60, are of the second conductivity type, here P-type, and have a higher doping level with respect to the body regions 60. For example, the body contact regions 80 have a doping level comprised between 1·10¹⁸ atoms/cm³ and 1·10²⁰ atoms/cm³. Therefore, in Figure 3, the body contact regions 80 are of P+ type.

In practice, the width of the body contact region 80, along the second direction X, is equal to the distance between the source regions 65.

In addition, the body contact regions 80 have a length, along the third axis Y, much greater than the width, along the second axis X. For example, the body contact regions 80 have a length, along the third axis Y, greater than at least one hundred times, in general hundreds of times the width.

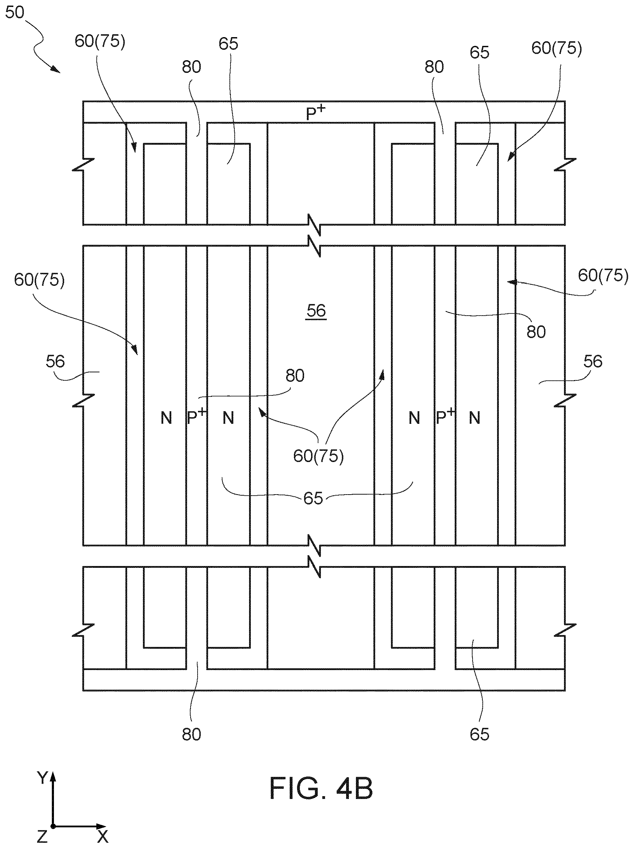

The body contact regions 80 have a shape similar to that of the source regions 65 and extend uninterruptedly therein throughout or approximately throughout their extension, as discussed below, with reference to Figure 4B.

In particular, in the MOSFET device 50 of Figures 3 and 4A, the body contact regions 80 extend longitudinally (parallel to the second axis Y of the Cartesian reference system), inside the source regions 65.

The MOSFET device 50 also comprises a plurality of insulated gate regions 70. The insulated gate regions 70 are each formed by a gate insulating layer 71, in contact with the first surface 55A of the substrate 55; a gate conductive layer 72, directly superimposed on the gate insulating layer 71; and a passivation layer 73, covering the gate conductive layer 72 and sealing, together with the gate insulating layer 71, the gate conductive layer 72.

In detail, the gate insulating layer 71 of an insulated gate region 70 extends over a respective surface portion 56 of the drain region 57, on two channel regions 75 adjacent to the respective surface portion 56, and partially on two source regions 65 adjacent to the respective channel regions 75.

The gate conductive layers 72 of the insulated gate regions 70 are electrically connected in parallel, in a manner not shown here, forming a gate terminal G of the MOSFET device 50.

The MOSFET device 50 also comprises a source metallization region 83.

The source metallization region 83, for example of metal and/or metal silicide, forms the source terminal S of the MOSFET device 50 and extends over the first surface 55A of the substrate 55, in direct electrical contact with the source regions 65 and the body contact regions 80.

As indicated above, the body contact regions 80 may extend inside the source regions 65 throughout their extension. This is shown in Figure 4B wherein, for clarity of illustration, the source metallization 83 and the insulated gate regions 70 are not shown and the body contact regions 80 are even longer than the source regions 65.

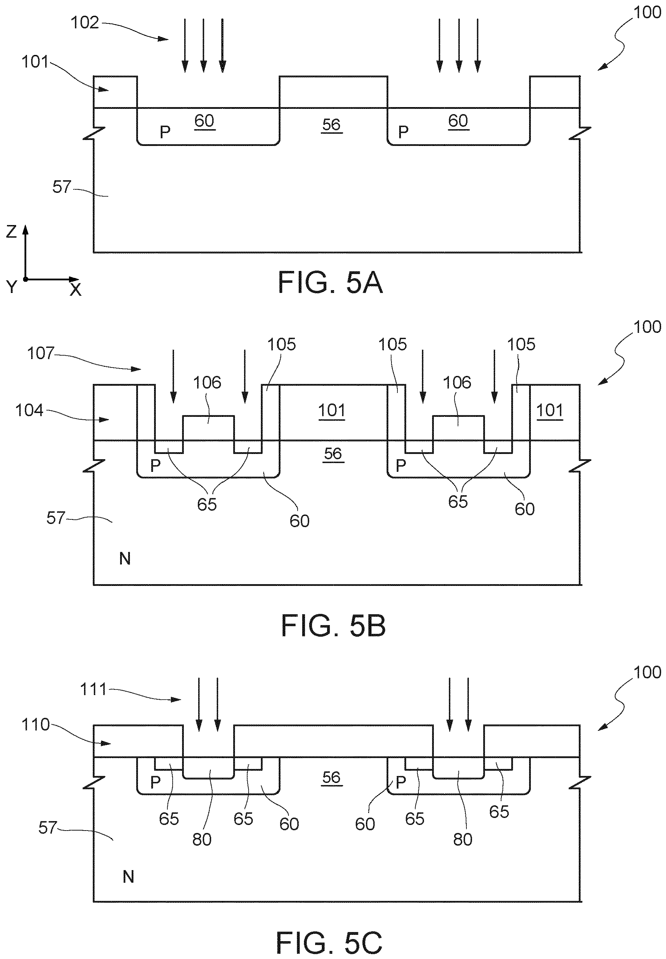

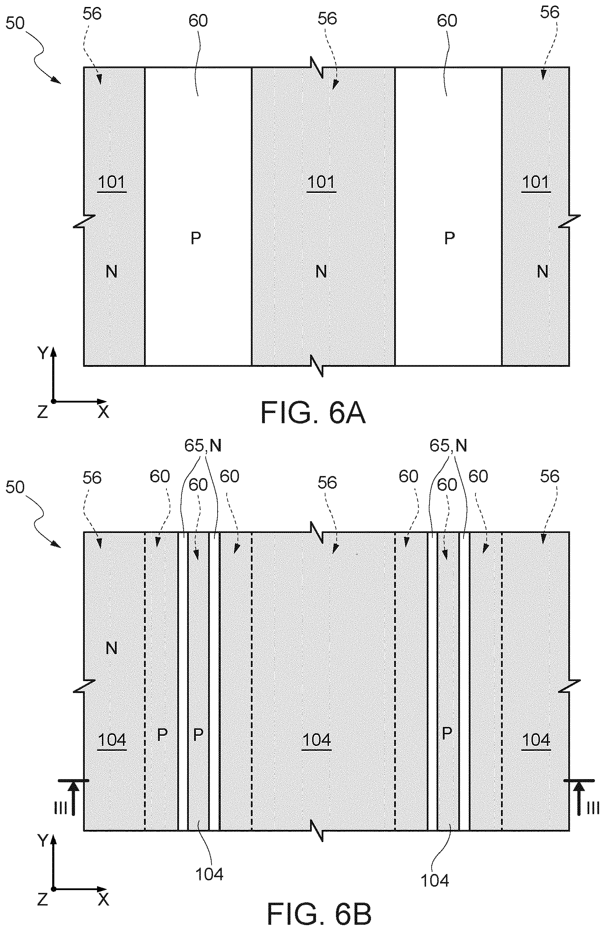

Fabrication of the MOSFET device 50 comprises manufacturing steps similar to those of known devices, andonly the modification of the body contact and source masks,as discussed below in detail with reference to Figures 5A-5C and 6A-6C.

In detail, Figures 5a and 6a show a wafer 100 of silicon carbide, here having an N-type doping.

In Figure 5A, the wafer 100 is processed to form the body regions 60 inside the drain region 57. In particular, using a body mask 101, for example of silicon oxide, which covers the surface portions 56 of the drain region 57, a masked implantation of P-type doping ions, such as aluminum or boron ions, is carried out, as schematically represented in Figure 5A by arrows 102. After the implant, an annealing may follow for activating the doping ions and reducing the defects in the crystalline lattice.

The implantation (with relative annealing) may occur in successive steps, also including successive epitaxial growths, using respective masks equal to each other, in a manner not shown.

In Figures 5B and 6B, a source mask 104 is formed on the wafer 100, for example starting from the body mask 101 of Figure 5A. In this case, a masking layer, for example of oxide again, is deposited, lithographically defined to cover it at the center of the body regions 60 and then etched anisotropically, so as to form source mask 104 having, above the body regions 60, side portions or spacers 105 on the sides of portions of body mask 101 and islands 106 at the center of the body regions 60, extending therealong. The source mask 104 also covers the surface portions 56 of the drain region 7.

In particular, in the embodiment shown in Figure 4B, the side portions 105 and the islands 106 extend throughout the length of the body regions 60 in the direction of the second axis Y, so that the etch to form them affects them in a uniform manner.

Using the source mask 104, N-type doping ions, such as nitrogen or phosphorus ions, are implanted inside the body regions 60 and form the source regions 65 (arrows 107).

After the source implant, the wafer 100 may be subject to an annealing step, in a known manner.

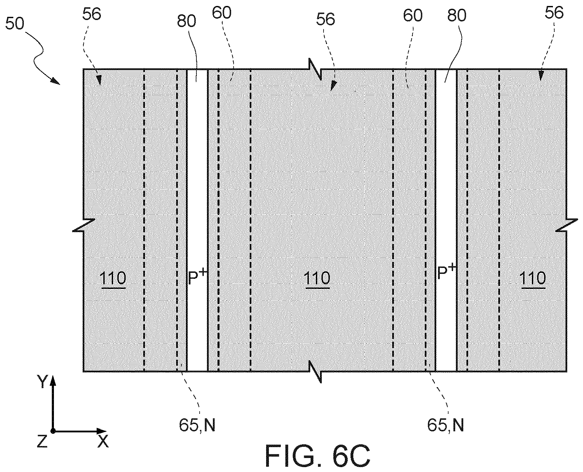

Figures 5C and 6C show the manufacturing step of the body contact regions 80.

In detail, after removing the source mask 104, a body contact mask 110 is formed, which covers the surface portions 56 of the drain region 57 and, above the body regions 60, has a shape complementary with respect to the source mask 104.

In particular, the body contact mask 110 covers the newly implanted source regions 65 and leaves uncovered only the portions of the body regions 60 wherein it is desired to form the body contact regions 80.

Then, using the body contact mask 110, the body contact regions 80 are implanted. The implant is performed at a high dose (for example comprised between 10¹⁴-5.10¹⁵), and suitable energy (for example comprised between 10 keV and 300 keV).

After a possible annealing step and the removal of the body contact mask 110, the wafer 100 is processed in a known manner, forming the insulated gate regions 70 on the wafer 100, the source metallization region 83 and the drain metallization region 59; then the wafer 100 is diced and provided with electrical connections to obtain the device 50 of Figures 3, 4A and 4B.

The MOSFET device 50 and the manufacturing process thereof, here described, have numerous advantages.

In particular, by virtue of to the continuity of the body contact regions 80, the MOSFET device 50 has a more uniform electric field distribution in the contact areas with the source regions 65 and body contact regions 80 with respect to similar known devices.

Furthermore, the charge carriers (recombinant holes) which move from the channel regions 75 towards the body contact regions 80 during turning off (diode operation) described above, find uniform paths and the paths for the charge carriers have substantially uniform resistivity along the extension of the body strips (along the second axis Y).

Furthermore, in the MOSFET device 50 etch loading effects are no longer preset due to islands and discontinuities in the source mask 104.

The MOSFET device 50 has therefore improved electrical characteristics.

Finally, it is clear that modifications and variations may be made to the device and manufacturing process described and illustrated herein without thereby departing from the scope of the present invention, as defined in the attached claims.

For example, in case the body regions 6 and/or the source regions 65 have a ring shape, in top view, the body contact regions 80 may also have a continuous annular shape, without interruptions.

Instead of forming two separate source regions 65, shielding the implant of Figure 5B, the source implant might also be performed in the area of the body contact region 80 and the implant of the latter (Figure 5C) be carried out with a higher dose.

In summary, the MOSFET device of a vertical conduction type comprises:
a substrate (55) of silicon carbide having a first conductivity type and a main face (55A);
a body region (60) of a second conductivity type, extending into the substrate, from the main face, the body region having a first depth along a first direction (Z);
a first and a second source region (65) of the first conductivity type, extending inside the body region (60), starting from the main face, parallel to each other, the source regions (65) having a second depth, along the first direction (Z), smaller than the first depth and being mutually spaced by a distance, in a second direction (X), perpendicular to the first direction (Z), the source regions (65) extending in an extension direction (Y), locally perpendicular to the first and the second directions (Z, X);
a body contact region (80), of the second conductivity type, extending inside the body region (60), between the first and the second source regions (65), the body contact region (80) having a third depth, along the first direction, greater than or equal to the second depth (Z),
wherein the body contact region (80) has a width, in the second direction (X) and a length, in the extension direction (Y), much greater than the width.

The body region (60) has a length, in the extension direction (Y), at least one hundred times the width.

The body contact region (80) extends continuously along the extension direction.

The body contact region (80) may extend throughout the length of the source regions.

The body contact region (80) may be a single body contact region (80).

The width of the body contact region (80), in the second direction (X), may be equal to the distance between the source regions (65).

The body contact region (80) may be contiguous to the source regions (65).

The body region (60) may have a first doping level and the body contact region (80) may have a second doping level, higher than the first doping level.

The extension direction may be a rectilinear longitudinal direction and the first, second and third directions may be Cartesian axes.

The first conductivity type may be N and the second conductivity type may be P.

A process for manufacturing a MOSFET device comprises:
forming, in a substrate (55) of silicon carbide having a first conductivity type and a main face (55A), a body region (60) of a second conductivity type, the body region extending from the main face, having a first depth along a first direction (Z);
forming, inside the body region (60), a first and a second source region (65) of the first conductivity type, extending from the main face and parallel to each other, the source regions (65) having a second depth, along the first direction, smaller than the first depth, being mutually spaced by a first distance, in a second direction (X), perpendicular to the first direction (Z), and extending in an extension direction (Y), locally perpendicular to the first and the second directions (Z, X);
forming, inside the body region (60), between the first and the second source regions (65), a body contact region (80), of the second conductivity type, starting from the main face, the body contact region (80) having a third depth, along the first direction, greater than or equal to the second depth,
wherein the body contact region (80) has a width, in the second direction (X) and a length, in the extension direction (Y), much greater than the width.

Forming the first and the second source regions (65) may comprise introducing first doping ions, capable of conferring the first conductivity type, using a first mask (104), and wherein forming a body contact region (80) comprises introducing second doping ions, capable of conferring the second conductivity type, using a second mask (110) having masking portions extending to a second distance equal to the first distance and superimposed on the first and the second source regions (65).

The second mask (110) may have a masking portion, above the body region (60), complementary to the first mask (104).

## Claims

1. A MOSFET device (50) of a vertical conduction type comprising:
a substrate (55) of silicon carbide having a first conductivity type and a main face (55A);
a body region (60) of a second conductivity type, extending into the substrate (55) from the main face, the body region having a first depth along a first direction (Z) ;
a first and a second source region (65) of the first conductivity type, extending inside the body region (60), from the main face, parallel to each other, the first and second source regions (65) having a second depth, along the first direction (Z), smaller than the first depth and being mutually spaced by a distance, in a second direction (X), perpendicular to the first direction (Z), the first and second source regions (65) extending in an extension direction (Y), locally perpendicular to the first and the second directions (Z, X);
a body contact region (80), of the second conductivity type, extending inside the body region (60), between the first and the second source regions (65), the body contact region (80) having a third depth, along the first direction, greater than or equal to the second depth (Z),
wherein the body contact region (80) has a width, in the second direction (X) and a length, in the extension direction (Y), greater than the width.

2. The MOSFET device according to claim 1, wherein the length of body contact region (80) is at least one hundred times the width of the body contact region (80).

3. The MOSFET device according to claim 1 or 2, wherein the body contact region (80) extends continuously along the extension direction.

4. The MOSFET device according to any of the preceding claims, wherein the body contact region (80) extends throughout the length of the source regions (65).

5. The MOSFET device according to any of the preceding claims, wherein the body contact region (80) is a single body contact region (80).

6. The MOSFET device according to any of the preceding claims, wherein the width of the body contact region (80), in the second direction (X), is equal to the distance between the source regions (65).

7. The MOSFET device according to any of the preceding claims, wherein the body contact region (80) is contiguous to the source regions (65).

8. The MOSFET device according to any of the preceding claims, wherein the body region (60) has a first doping level and the body contact region (80) has a second doping level, higher than the first doping level.

9. The MOSFET device according to any of the preceding claims, wherein the extension direction is a rectilinear longitudinal direction and the first, second and third directions are Cartesian axes.

10. The MOSFET device according to any of the preceding claims, wherein the first conductivity type is N and the second conductivity type is P.

11. A process for manufacturing a MOSFET device comprising:
forming, in a substrate (55) of silicon carbide having a first conductivity type and a main face (55A), a body region (60) of a second conductivity type, the body region extending from the main face and having a first depth along a first direction (Z);
forming, inside the body region (60), a first and a second source region (65) of the first conductivity type, extending from the main face and parallel to each other, the first and second source regions (65) having a second depth, along the first direction, smaller than the first depth, being mutually spaced by a first distance, in a second direction (X), perpendicular to the first direction (Z), and extending in an extension direction (Y), locally perpendicular to the first and the second directions (Z, X); and
forming, inside the body region (60), between the first and the second source regions (65), a body contact region (80), of the second conductivity type, extending from the main face, the body contact region (80) having a third depth, along the first direction, greater than or equal to the second depth,
wherein the body contact region (80) has a width, in the second direction (X) and a length, in the extension direction (Y), much greater than the width.

12. The process according to the preceding claim, wherein forming the first and the second source regions (65) comprises introducing first doping ions, capable of conferring the first conductivity type, using a first mask (104), and wherein forming a body contact region (80) comprises introducing second doping ions, capable of conferring the second conductivity type, using a second mask (110) having masking portions extending to a second distance equal to the first distance and superimposed on the first and the second source regions (65).

13. The process according to the preceding claim, wherein the second mask (110) has a masking portion, above the body region (60), complementary to the first mask (104).

14. The process according to claim 12 or 13, comprising:
forming a body mask (101) and performing a first ion implantation process in a presence of the body mask to form the body region (60);
performing a first thermal annealing process;
performing a second ion implantation process in presence of the first mask (104) to form the first and second source regions;
performing a second thermal annealing process;
performing a third ion implantation process in presence of the second mask (110) to form the body contact region and
performing a third thermal annealing process.

15. The process according to the preceding claim, comprising forming the first mask (104) at least partially on top of the body mask (101).
